# EUROPEAN PATENT SPECIFICATION

(11) **EP 4 174 920 B1**
(45) Date of publication and mention of the grant of the patent: **25.11.2026**
(21) Application number: 22204475.2
(22) Date of filing: 28.10.2022
(51) Int. Cl.: H10P 72/10

(54) **A SEMICONDUCTOR SUBSTRATE PROCESSING APPARATUS**
VORRICHTUNG ZUR BEHANDLUNG VON HALBLEITERSUBSTRATEN
APPAREIL DE TRAITEMENT DE SUBSTRAT SEMI-CONDUCTEUR

(30) Priority: 02.11.2021 US 202163274666 P
(43) Date of publication of application: 03.05.2023
(73) Proprietor: ASM IP Holding B.V., 1322 AP Almere (NL)
(72) Inventor: OOSTERLAKEN, Theodorus G.M., 1322 AP Almere (NL); PIERREUX, Dieter, 3001 Leuven (BE)
(74) Representative: V.O.

(56) References cited:
- WO-A1-2005/076343
- US-A- 5 618 351
- US-A- 5 897 311

## Description

### FIELD OF THE DISCLOSURE

The present disclosure generally relates to a semiconductor substrate processing apparatus.

### BACKGROUND

In a semiconductor substrate processing apparatus, such as a vertical batch furnace, atomic layer deposition (ALD) apparatus, and the like, a wafer may be treated in a process chamber by depositing a layer of deposition material on said wafer. The wafer may be loaded in a wafer boat which may accommodate a plurality of spaced apart wafers. The wafer boat with loaded wafers may be placed in the process chamber for treatment. Uniform depositing of the material on the wafer in the wafer boat may be important for obtaining high quality wafers. A known problem may be the accumulation of deposited material near an outer edge of the wafer, i.e. in an outer edge zone of the wafer, making the layer in said outer edge zone thicker than elsewhere on the wafer. This edge effect may decrease the quality of the wafer and may reduce the effective area of the wafer. Also posts of the wafer boat containing slots by which the wafers are supported may disturb the deposition process so that the layer thickness which is deposited on the wafer adjacent the posts may be different from the layer thickness at parts of the wafer which are more remote from the posts.

It is known to put a shielding ring in a slot in the wafer boat above the wafer, wherein the shielding ring shields the outer edge zone of the wafer against superfluous deposition.

US 5 897 311 discloses semiconductor substrate processing apparatus comprising a wafer boat provided with a plurality of wafer supports, each wafer support comprising a support area configured to support at least a circumferential edge of a wafer of the plurality of wafers; and comprising a flange circumferentially surrounding the support area. The flange is received in and supported by slots in wafer boat posts. The flange has a width that creates a distance between the circumferential edge of each wafer and the wafer boat posts of the wafer boat.

WO2005076343A1 discloses a wafer boat with placing shelves each configured for supporting a wafer.

### SUMMARY

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

It may be realized that in the known substrate processing apparatus using the shielding rings, deposition material is still accumulated near and deposited on the outer edge zone of the wafer.

It may be an object to provide a semiconductor processing apparatus in which the accumulation of deposition material on the outer edge zone of the wafer is less than in the known semiconductor processing apparatus.

To that end, there may be provided a semiconductor substrate processing apparatus. The semiconductor substrate processing apparatus may comprise a processing chamber, a wafer boat, and a shield ring. The processing chamber may be configured for batch processing a plurality of wafers. The processing may include depositing a layer on each wafer of the plurality of wafers. The wafer boat may be configured to accommodate the plurality of wafers and be receivable in the processing chamber. The wafer boat may comprise at least two wafer boat posts. Each wafer boat post may comprise a plurality of slots. The shield ring may be configured to be supported in the slots of the wafer boat posts above an associated wafer. The shield ring may shield a circumferential outer edge zone at an upper surface of the associated wafer. The circumferential outer edge zone may be ring-shaped, have a radial width and extend circumferentially along a circumferential edge of the wafer. A surface part of the shield ring may define a nominal surface area which is a surface area of the surface part if it were flat. The surface part has a surface structure which may provide an enhanced surface area. An enhanced surface area ratio may be defined by the enhanced surface area of the surface part having the surface structure divided by the nominal surface area. The enhanced surface area ratio is higher than 1.5.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught or suggested herein without necessarily achieving other objects or advantages as may be taught or suggested herein.

Various embodiments are claimed in the dependent claims, which will be further elucidated with reference to an example shown in the figures. The embodiments may be combined or may be applied separate from each other.

All of these embodiments are intended to be within the scope of the invention herein disclosed. The invention is defined by the appended claims. These and other embodiments will become readily apparent to those skilled in the art from the following detailed description of certain embodiments having reference to the attached figures, the invention not being limited to any particular embodiment(s) disclosed.

### BRIEF DESCRIPTION OF THE FIGURES

While the specification concludes with claims particularly pointing out and distinctly claiming what are regarded as embodiments of the invention, the advantages of embodiments of the disclosure may be more readily ascertained from the description of certain examples of the embodiments of the disclosure when read in conjunction with the accompanying drawings, in which:
Fig. 1 shows an example of a semiconductor substrate processing apparatus according to the description;
Fig. 2 shows a schematic and exaggerated representation of a thickness of a deposited layer on a wafer, in particular at a cross-section through the wafer which contains two edge zone areas of the wafer which have been remote from the posts of the wafer boat in which the wafer was placed when being processed, wherein no shield rings were present in a wafer boat during processing;
Fig. 3a shows a schematic cross section view of an example of a known wafer boat with wafers placed therein, in particular at a cross-section through the wafer posts of the wafer boat;
Fig. 3b shows a schematic and exaggerated representation of a thickness of a deposited layer on the wafers in the wafer boat as depicted in Fig. 3a along the shown cross section through the wafer boat posts when no shield rings are used during processing;
Fig. 4 shows a schematic cross section view of an example according to the description of a wafer boat with wafers and wafer supports placed therein;
Fig. 5 shows a schematic cross section view of an example according to the description of a wafer boat with wafer supports and wafers placed therein;
Fig. 6 shows a schematic cross section view of an example according to the description of a wafer boat with wafers and shield rings placed therein;
Fig. 7 shows a schematic representation of a nominal and an enhanced surface area of an surface part with an enhanced surface area of a shield ring according to the description; and
Fig. 8 shows a cross-sectional detail of the right-hand part of a wafer support as shown in Fig. 5.

### DETAILED DESCRIPTION

In this application similar or corresponding features are denoted by similar or corresponding reference signs. The description of the various embodiments is not limited to the examples shown in the figures and the reference numbers used in the detailed description and the claims are not intended to limit the description of the embodiments, but are included to elucidate the embodiments.

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below. The illustrations presented herein are not meant to be actual views of any particular material, structure, or device, but are merely idealized representations that are used to describe embodiments of the disclosure.

As used herein, the term "wafer" may refer to any underlying material or materials that may be used, or upon which, a device, a circuit, or a film may be formed.

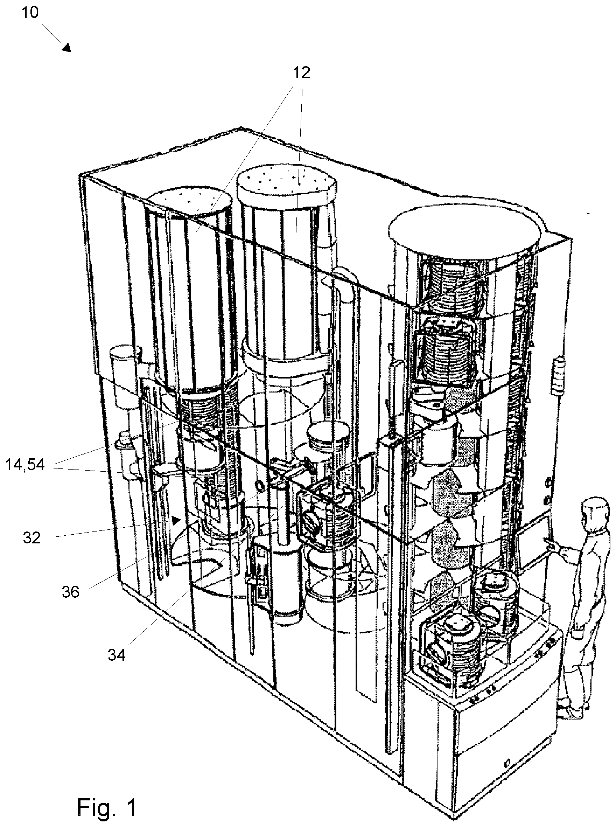

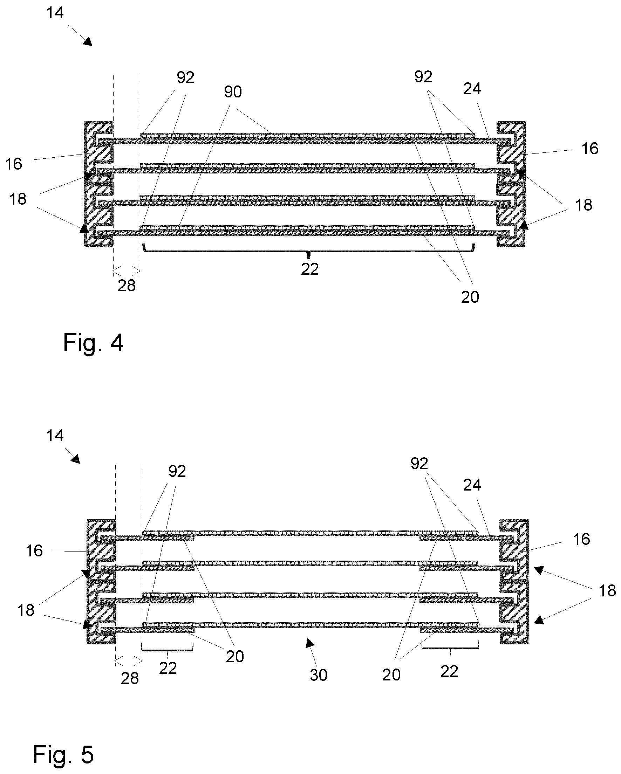

In the most general terms the present disclosure may provide a semiconductor substrate processing apparatus 10. An example of the semiconductor substrate processing apparatus 10 is shown in figures 1. The semiconductor substrate processing apparatus 10 may comprise a processing chamber 12, a wafer boat 14, and a plurality of wafer supports 20. Examples of the wafer boat 12 with wafer supports 20 and wafers 90 are shown in figures 4 and 5. The processing chamber 12 may be configured for batch processing a plurality of wafers 90. The processing may include depositing a layer on each wafer 90 of the plurality of wafers 90. The wafer boat 14 may be configured to accommodate the plurality of wafers 90 and be receivable in the processing chamber 12. The wafer boat 14 may comprise at least two wafer boat posts 16. Each wafer boat post 16 may comprise a plurality of slots 18. Each wafer support 20 of the plurality of wafer supports 20 may comprise a support area 22 and a flange 24. The support area may be configured to support at least a circumferential edge 92 of a wafer 90 of the plurality of wafers 90. The flange 24 may circumferentially surround the support area 22. The flange 24 may be receivable in and be supported by the slots 18. The flange 24 may have a width to create a distance 28 between the circumferential edge 92 of the wafer 90 of the plurality of wafers 90 and the wafer boat posts 16 of the wafer boat 14. The distance may be such that the wafer boat posts 16 do substantially not influence a layer thickness of the layer which is deposited on the wafer 90 during processing of the wafer 90.

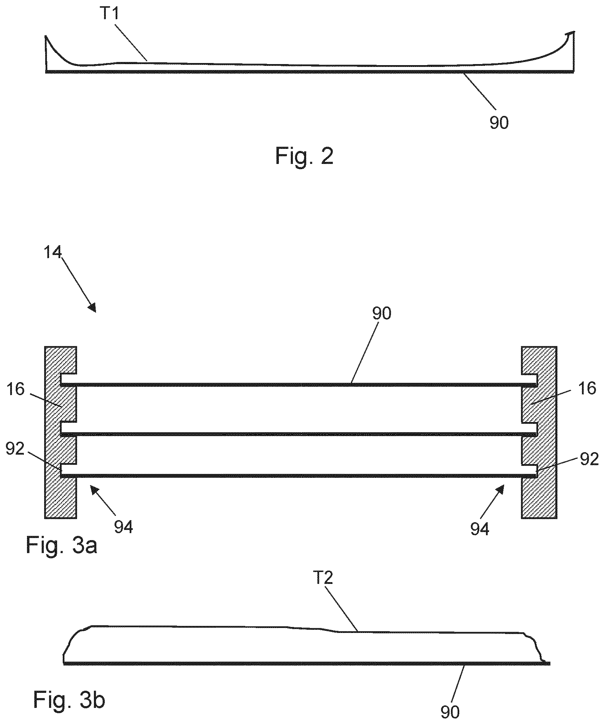

During deposition a precursor gas may be supplied in the processing chamber 12. This precursor gas may be deposited on the wafer 90 and form a layer of deposition material thereupon. The deposition of material on the wafer 90 may not always be uniform, which means that a layer thickness may vary. Figures 2 and 3b may show typical layer thickness profiles T1 and T2 over a wafer 90. The dimensions of the layer thicknesses shown in Figures 2 and 3b are not on the same scale as the diameter of the wafer 90 shown. Figure 2 may show a typical layer thickness profile over a wafer 90 processed in a wafer boat 14 with no shield ring 62 present. The outer edge zone 94 may have been remote from the wafer boat posts 16 during processing. As is shown in figure 2, the edge effect may result in an accumulation of deposition material at or near the wafer edge 92 in the outer edge zone 94. Figure 3b may show a typical layer thickness profile over a wafer 90 processed in a wafer boat 14, wherein the two outer edge zones 94 may have been adjacent the posts 16 of the wafer boat 14 in which the wafer 90 was placed when being processed, as may be seen in Figure 3a. As is shown in Figure 3b, the wafer posts 16 may cause that less material may be deposited on the wafer 90 near the wafer boat posts 16 resulting in a reduced layer thickness in an area adjacent the wafer boat posts relative the layer thickness in other areas of the wafer 90 which are more remote from the wafer boat posts 16. Combined these two effects may be superimposed and cause various kinds of deviations in the layer thickness in the edge zone 94 and adjacent the wafer boat posts 16.

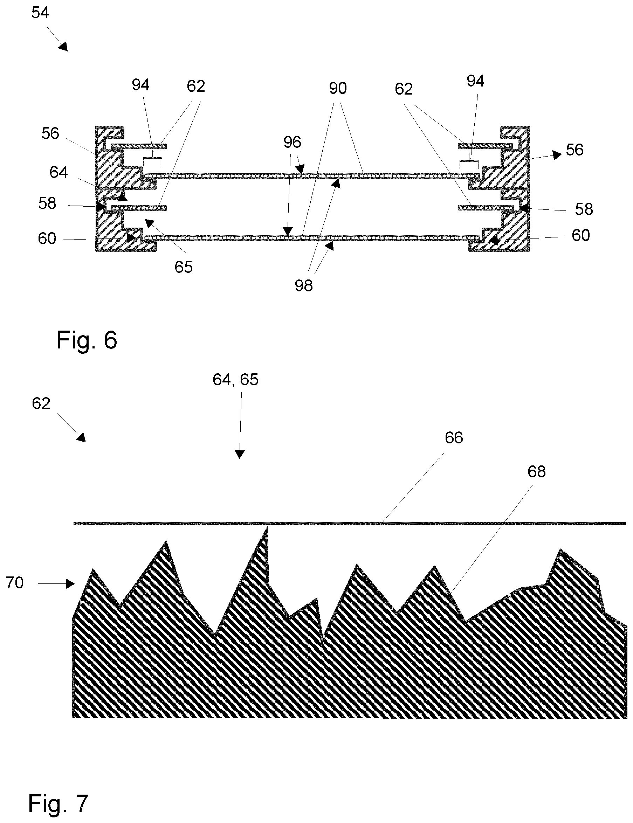

To counter the edge effect, the known semiconductor substrate processing apparatus may have a wafer boat with wafers and shield rings placed therein. The setup of this known wafer boat may be similar to the one shown in figure 6. But even in this set-up, the above described edge effect may not be solved in all processes and the above described effect of the wafer boat posts 16 on the layer thickness is not solved either.

In the semiconductor substrate processing apparatus 10 of the present disclosure, the flange 24 may create the distance 28 between the circumferential edge 92 of the wafer 90 and the wafer boat posts 16. This may result in a wafer boat 14 in which the wafer boat posts 16 are further away from the circumferential edge 92 of the wafer 90 than in the wafer boat of the known semiconductor substrate processing apparatus. The width may be chosen such that the thicker part of the deposited layer may be formed on the flange 24 of the wafer support 20 and not on the outer edge zone 92 of the wafer 90. Additionally, the above described undesired effects of the wafer boat posts 16 on the layer thickness of the deposited layer adjacent the wafer boat posts 16 may be reduced. This may lead to a more even distribution of deposited material on the wafer 90 itself, thereby improving the quality of the wafer 90.

As shown in figure 1, the semiconductor substrate processing apparatus 10 may comprise a wafer boat chamber 32 situated below the processing chamber 12. The wafer boat 14 may be configured to be transferred between the wafer boat chamber 32 and the processing chamber 12. The wafer boat chamber 32 may comprise a wafer handling robot 34, which may be configured to transfer wafers 90 to and from the wafer boat 14. An end effector 36 of the wafer handling robot 34 may be configured to engage the wafer 90.

In an embodiment the width of the flange 24 to create the distance between the circumferential edge 92 of the wafer 90 and the wafer boat posts 16 may be in the range between 5 and 35 mm, preferably between 10 and 25 mm, more preferably substantially 15 mm. This width of the flange 24 may suffice to reduce the influence of the wafer boat posts 16 on the layer thickness.

In an embodiment the distance 28 between the circumferential edge 92 of the wafer 90 and the wafer boat posts 16 may be in the range between 5 and 35 mm, preferably between 10 and 25 mm, more preferably substantially 10 mm. This distance between the wafer 90 and the wafer boat posts 16 may suffice to substantially reduce the influence of the wafer boat posts 16 on the layer thickness.

In an embodiment, of which an example is shown in figure 4, the support area 22 may be closed so that the wafer support 20 may be substantially plate-shaped and capable of supporting an entire bottom surface 98 of a wafer 90. The wafer support 20 may thus fully support the wafer 90 and may at the same time shield the bottom surface 98 from any deposited material. Especially in high process temperature applications, a fully supported wafer may be preferred to prevent bending of the wafer in the central region.

In an embodiment, of which an example is shown in figure 5, the support area 22 may comprise a central opening 30 so that the wafer support 20 may be substantially ring-shaped. Such a wafer support 20 may have less material and may thus be lighter and cheaper to manufacture than the plate-shaped wafer support 20 discussed above.

In an embodiment, the wafer support 20 with the wafer 90 may be removable from the wafer boat 14. An end effector 36 or the like, may be used to transport the wafer support 20. The end effector 36 may, for example, engage a bottom surface of the wafer support 20 and may carry the wafer support 20 together with the wafer 90.

In an embodiment the wafer support 20 may comprise quartz. Quartz may ensure that high purity is maintained while being able to withstand high temperature, while not reacting with the wafers 90 themselves or introducing particles which may cause impurities in the deposited layers..

In an embodiment the wafer support 20 may comprise silicon carbide (SiC). As quartz, silicon carbide may be a material with high temperature resistance.

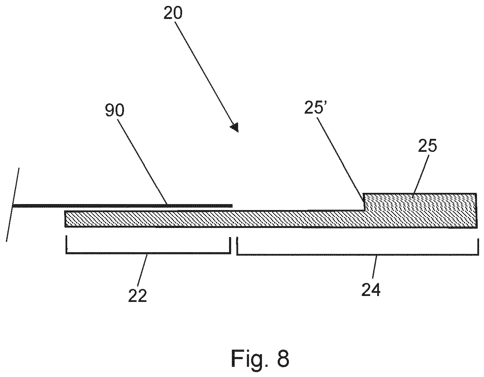

In an embodiment, of which an example is shown in Fig. 8, the wafer support 20 may comprise a thickened edge portion 25 which forms a wafer catching edge 25'. This wafer catching edge 25' may prevent that a wafer 90 which is placed on the wafer support 20 may slip off the wafer support 20 during handling with the wafer handling robot 34. The thickened portion 25 may be integrally formed with the flange 24 of the wafer support 20 but may also be formed by a separate ring element which is connected on an upper surface of the wafer support 20.

The present disclosure may also provide another semiconductor substrate processing apparatus 10. The semiconductor substrate processing apparatus 50 may comprise a processing chamber 12, a wafer boat 54, and a shield ring 62. Examples of the wafer boat 54 of this example are shown in figures 6 and 7. The processing chamber 12 may be configured for batch processing a plurality of wafers 90. The processing may include depositing a layer on each wafer 90 of the plurality of wafers 90. The wafer boat 54 may be configured to accommodate the plurality of wafers 90 and be receivable in the processing chamber 12. The wafer boat 54 may comprise at least two wafer boat posts 56. Each wafer boat post 56 may comprises a plurality of slots 58, 60. The shield ring 62 may be configured to be supported in the slots 58, 60 of the wafer boat posts 56 above an associated wafer 90. The shield ring 62 may shield a circumferential outer edge zone 94 at an upper surface 96 of the associated wafer 90. The circumferential outer edge zone 94 may be ring-shaped, having a radial width and extending circumferentially along a circumferential edge 92 of the wafer 90. A surface part 64, 65 of the shield ring 62 may define a nominal surface area 66 which is a surface area of the surface part 64, 65 if it were flat. The surface part 64, 65 may have a surface structure 70 which provides an enhanced surface area 68. An enhanced surface area ratio may be defined by the enhanced surface area 68 of the surface part 64, 65 having the surface structure 70 divided by the nominal surface area 66. The enhanced surface area ratio may be higher than 1.5.

A physical surface may have an enhanced surface area which may be different from the nominal surface area 66. An illustration hereof is shown in Fig. 7. The nominal surface area 66 may be a theoretical area which is completely flat. On a molecular scale every physical surface may have a topology or surface structure of the molecules or atoms which make up the material of which the surface is made. This topology or surface structure may determine the enhanced surface area 68. This may mean that for physical surfaces the enhanced surface area ratio is greater than one.

As with the previous semiconductor substrate processing apparatus 10, due to the edge effect the thickness of the deposited layer may be thicker in the outer edge zone 94 of the wafer 90 than in more central parts of the wafer 90. Although the known shield ring may shield the circumferential outer edge zone 94 at an upper surface 96 of the wafer 90, there still may be an accumulation of deposition material on said outer edge zone 94. With the shield ring 62 according to the description having a surface part 64 and/or 65 with an enhance surface area 68, such an accumulation of deposition material may be reduced.

With the surface part 64, 65 of the shield ring 62 which may have an enhanced surface area ratio of more than 1.5, more deposition material may be prevented from being deposited on the circumferential outer edge zone 94 of the wafer 90. This may even have as a result that no accumulation of deposition material on the circumferential outer edge zone 94 of the wafer 90 occurs and that a uniform layer thickness is obtained over at least the entire upper surface of the wafer 90.

Because of the high enhanced surface area ratio, the surface part 64 and/or 65 with the enhanced surface area 68 may have a relatively high roughness which may result in more deposition material adhering to the surface part 64 and/or 65 of the shield ring 62 according to the descripting thus reducing the edge effect.

Continuous use of the shield ring 62 during processing, may result in the deposition material smoothening the enhanced surface area. This may lead to the enhanced surface area ratio becoming smaller. To ensure the level of enhanced surface area ratio, it may be necessary to periodically treat the surface part 64, 65 of the shield ring 64 having the enhanced surface area ratio. The surface part 64 and/or, 65 of the shield ring 62 may e.g. be treated with an etching process to remove deposited material from the shield ring 62.

In an embodiment, the surface part of the shield ring 62 with the enhanced surface area 68 may exclusively comprise an upper surface 64 of the shield ring 62.

In an alternative embodiment, the surface part of the shield ring 62 with the enhanced surface area 68 may exclusively comprise a lower surface 65 of the shield ring 62.

In yet another alternative embodiment, the surface part of the shield ring 62 with the enhanced surface area 68 may comprise both an upper surface 64 and a lower surface 65 of the shield ring 62.

Which choice from these three embodiments is made depends on the type of deposition process and the materials used. It will be clear that the position of the enhanced surface area 68 on an upper surface 64, a lower surface 65 or on both may have an impact on the edge effect and thus on the layer thickness in the outer edge zone 94 of the wafer 90.

In an embodiment, the enhanced surface area ratio may be higher than 20, preferably higher than 50. This value of the enhance surface area ratio may be enough to prevent any accumulation of deposition material on the outer edge zone 94 of the wafer 90.

In an embodiment, the surface structure 70 may comprise a coating which provides a roughness. The coating may have a thickness between 500 nm to 5000 nm. Such a coating may provide the enhanced surface area 68 with the enhanced surface area ratio higher than 1.5, preferably higher than 20, and even more preferably higher than 50.

In an embodiment, the surface structure 70 may comprise a coating including hemi-spherical grains.

In an embodiment, the shield ring 62 may be manufactured from a construction material. The surface structure 70 may comprise geometrical shapes which are provided in the construction material to provide the enhanced surface area with the enhanced surface area ratio of the present disclosure. For example, the surface part 64, 65 of the shield ring 62 with the enhanced surface area 68 may be milled in a rough milling operation to provide the enhanced surface area.

In an embodiment, the surface part 64 and/or 65 with the enhanced surface area 68 may comprise a coating comprising silicon dioxide SiO₂.

In an embodiment, at least the surface part 64 and/or 65 of the shield ring 62 with the enhanced surface area 68 may comprise porous material. The porous material may comprise e.g. porous silicon oxide.

In an embodiment, the shield ring 92 may have a radial width which is selected such that the circumferential outer edge zone 94 which is shielded by the shield ring 92 may have a width in the range of 10 mm to 30 mm. This radial width may be enough to prevent the above-described edge effect.

In an embodiment, of which an example is shown in figure 5, the shield ring 62 may be at the same time a wafer support 20 comprising a support area 22 and a flange 24. The support area 22 may be configured to support at least a circumferential edge 92 of a wafer 90 of the plurality of wafers 90. The support area 22 may have a central opening 30 having a diameter which is smaller than a diameter of the wafer 90. The flange 24 may circumferentially surround the support area 22. The flange 24 may be receivable in and supported by the slots 18. The flange 24 may have a width to create a distance 28 between the circumferential edge 92 of the wafer 90 of the plurality of wafers 90 and the wafer boat posts 16 of the wafer boat 14. The distance 28 may be such that the wafer boat posts 16 do substantially not influence a layer thickness of the layer which is deposited on the wafer 90 during processing of the wafer 90.

As with the previous semiconductor substrate processing apparatus 10, the flange 24 may create the distance 28 between the circumferential edge 92 of the wafer 90 and the wafer boat posts 16. This may result in a wafer boat 14 in which the wafer boat posts 16 are further away from the circumferential edge 92 of the wafer 90 than in the wafer boat of the known semiconductor substrate processing apparatus. The width may be chosen such that the thicker part of the deposited layer caused by the edge effect may be formed on the flange 24 of the wafer support 20 and not on the outer edge zone 92 of the wafer 90. This may lead to a more even distribution of deposited material on the wafer 90 itself, thereby improving the quality of the wafer 90. The shield ring 62 for the associated wafer 90, which is at the same time the wafer support 20 for the wafer 90 directly above the associated wafer 90, not only reduces the edge effect due to the enhanced surface area of the shield ring 62 but also reduces the negative influence of wafer boat posts 56 on the uniformity of the layer thickness because the flange 24 of the wafer support 20/shield ring 62 provides an increased distance between the circumferential edge 92 of the wafer 90 and the wafer boat posts 56.

Again, in a further elaboration of this embodiment, of which an example is shown in Fig. 8, the wafer support 20 may comprise a thickened edge portion 25 which forms a wafer catching edge 25'. This wafer catching edge 25' may prevent that a wafer 90 which is placed on the wafer support 20 may slip off the wafer support 20 during handling with the wafer handling robot 34. The thickened portion 25 may be integrally formed with the flange 24 of the wafer support but may also be formed by a separate ring element which is connected on an upper surface of the wafer support 20.

In an alternative embodiment, of which an example is shown in figure 6, the shield ring 62 may, according to the present disclosure, have a surface part 64 and/or 65 with an enhanced surface area and may be accommodated in between wafers 90 in the wafer boat 54 in shield ring slots 58 which are positioned between wafer slots 60 of wafer boat posts 56 which are configured to accommodate wafers 90 in the wafer boat 54.

In this way each wafer 90 may be shielded by the shield ring 62 directly positioned above said wafer 90. In this embodiment, the shield ring 62 does not have the function of wafer support 20.

An advantage of the embodiment of Fig. 5 with wafer supports 20 which also serve as shield rings 62 due to the enhanced surface area thereof is that more wafers 90 may be placed in a wafer boat 18 having a certain height. This is because the end effector 36 requires a certain distance between the subsequent objects to be placed in the wafer boat 16. When between each wafer 90 in a wafer boat 56 a shield ring 62 has to be placed by the end effector 36, as is the case in the example shown in Fig. 6, the distance between subsequent wafers 90 is inevitably larger (as is visible in when comparing Fig. 6 with Fig. 5) than in the situation in which the wafer support 20 also has the shield ring function (as in Fig. 5) due to its enhanced surface area with the enhanced surface area ratio of higher than 1.5.

Although illustrative embodiments of the present invention have been described above, in part with reference to the accompanying drawings, it is to be understood that the invention is not limited to these embodiments. Variations to the disclosed embodiments can be understood and effected by those skilled in the art in practicing the claimed invention, from a study of the drawings, the disclosure, and the appended claims.

Reference throughout this specification to "one embodiment" or "an embodiment" means that a particular feature, structure or characteristic described in connection with the embodiment is included in at least one embodiment of the present invention which is defined by the appended claims. Thus, the appearances of the phrases "in one embodiment" or "in an embodiment" in various places throughout this description are not necessarily all referring to the same embodiment.

Furthermore, it is noted that particular features, structures, or characteristics of one or more of the various embodiments which are described above may be used implemented independently from one another and may be combined in any suitable manner to form new, not explicitly described embodiments. The reference numbers used in the detailed description and the claims do not limit the description of the embodiments, nor do they limit the claims. The reference numbers are solely used to clarify.

### Legend

- 10 -: semiconductor substrate processing apparatus
- 12 -: processing chamber
- 14 -: wafer boat
- 16 -: wafer boat post
- 18 -: slot
- 20 -: wafer support
- 22 -: support area
- 24 -: flange
- 25 -: thickened edge portion of wafer support
- 25' -: wafer catching edge
- 28 -: distance between the circumferential edge of the wafer and the wafer boat posts
- 30 -: central opening
- 32 -: wafer boat chamber
- 34 -: wafer handling robot
- 36 -: end effector
- 54 -: wafer boat
- 56 -: wafer boat post
- 58 -: shield ring slot
- 60 -: wafer slot
- 62 -: shield ring
- 64 -: upper surface (of shield ring)
- 65 -: lower surface (of shield ring)
- 66 -: nominal surface area
- 68 -: enhanced surface area
- 70 -: surface structure
- 90 -: wafer
- 92 -: circumferential edge (of wafer)
- 94 -: circumferential outer edge zone
- 96 -: upper surface (of wafer)
- 98 -: bottom surface (of wafer)
- T1 -: layer thickness at cross-section remote from wafer boat posts
- T2 -: layer thickness at cross-section comprising wafer boat posts

## Claims

1. A semiconductor substrate processing apparatus (10), comprising:
- a processing chamber (12) configured for batch processing a plurality of wafers (90), wherein the processing includes depositing a layer on each wafer (90) of the plurality of wafers (90);
- a wafer boat (14; 54) configured to accommodate the plurality of wafers (90) and receivable in the processing chamber (12), the wafer boat (54) comprising at least two wafer boat posts (16; 56), wherein each wafer boat post (16; 56) comprises a plurality of slots (18; 58, 60); and
- a shield ring (62) configured to be supported in the slots (18; 58) of the wafer boat posts (18; 56) above an associated wafer (90), the shield ring (62) shielding a circumferential outer edge zone (94) at an upper surface (96) of the associated wafer (90), the circumferential outer edge zone (94) being ring-shaped, having a radial width and extending circumferentially along a circumferential edge (92) of the wafer (90),
wherein
a surface part (64, 65) of the shield ring (62) defines a nominal surface area (66) which is a surface area of the surface part (64, 65) if it were flat, wherein the surface part (64, 65) has a surface structure (70) which provides an enhanced surface area (68),
wherein an enhanced surface area ratio is defined by the enhanced surface area (68) of the surface part (64, 65) having the surface structure (70) divided by the nominal surface area (66), wherein the enhanced surface area ratio is higher than 1.5.

2. The semiconductor substrate processing apparatus according to claim 1, wherein the surface part of the shield ring (62) with the enhanced surface area (68) exclusively comprises an upper surface (64) of the shield ring (62).

3. The semiconductor substrate processing apparatus according to claim 1, wherein the surface part of the shield ring (62) with the enhanced surface area (68) exclusively comprises a lower surface (65) of the shield ring (62).

4. The semiconductor substrate processing apparatus according to claim 1, wherein the surface part (64, 65) of the shield ring (62) with the enhanced surface area (68) comprises both an upper surface (64) and a lower surface (65) of the shield ring (62).

5. The semiconductor substrate processing apparatus according to any one of claims 1-4, wherein the surface structure (70) comprises a coating which provides a roughness.

6. The semiconductor substrate processing apparatus according to any one of claims 1-5, wherein the shield ring (62) is manufactured from a construction material, wherein the surface structure (70) comprises geometrical shapes which are provided in the construction material.

7. The semiconductor substrate processing apparatus according to any one of claims 1-6, wherein the surface part (64, 65) with the enhanced surface area (68) comprises a coating comprising silicon dioxide (SiO₂).

8. The semiconductor substrate processing apparatus according to any one of claims 1-7, wherein at least the surface part (64, 65) with the enhanced surface area (68) of the shield ring (62) comprises porous material.

9. The semiconductor substrate processing apparatus according to any one of claims 1-8, wherein the shield ring (92) has a radial width which is chosen such that the circumferential outer edge zone (94) which is shielded by the shield ring (92) has a width in the range of 10 mm to 30 mm.

10. The semiconductor substrate processing apparatus according to any one of claims 1-9, wherein the shield ring (62) is a wafer support (20) comprising:
a support area (22) configured to support at least a circumferential edge (92) of a wafer (90) of the plurality of wafers (90), wherein the support area (22) has a central opening (30) having a diameter which is smaller than a diameter of the wafer (90); and
a flange (24) circumferentially surrounding the support area (22), wherein the flange (24) is receivable in and supported by the slots (18), wherein the flange (24) has a width to create a distance (28) between the circumferential edge (92) of the wafer (90) of the plurality of wafers (90) and the wafer boat posts (18) of the wafer boat (54), wherein the distance (28) is such that the wafer boat posts (18) do substantially not influence a layer thickness of the layer which is deposited on the wafer (90) during processing of the wafer (90).

11. The semiconductor substrate processing apparatus according claim 10, wherein the wafer support (20) comprises a thickened edge portion (25) which forms a wafer catching edge (25').

12. The semiconductor substrate processing apparatus according to any one of claims 1-9, wherein the shield ring (62) is accommodated in between wafers (90) in the wafer boat (54) in shield ring slots (58) which are positioned between wafer slots (60) which are configured to accommodate wafers (90) in the wafer boat (54).

## Patentansprüche

1. Eine Halbleitersubstratverarbeitungsvorrichtung (10), umfassend:
- eine Verarbeitungskammer (12), die zur chargenweisen Verarbeitung einer Vielzahl von Wafern (90) konfiguriert ist, wobei die Verarbeitung das Abscheiden einer Schicht auf jedem Wafer (90) der Vielzahl von Wafern (90) umfasst;
- ein Waferboot (14; 54), das zur Aufnahme der Vielzahl von Wafern (90) konfiguriert und in der Verarbeitungskammer (12) aufnehmbar ist, wobei das Waferboot (54) mindestens zwei Waferbootpfosten (16; 56) umfasst, wobei jeder Waferbootpfosten (16; 56) eine Vielzahl von Schlitzen (18; 58, 60) umfasst; und
- einen Abschirmring (62), der dazu konfiguriert ist, in den Schlitzen (18; 58) der Waferbootpfosten (18; 56) über einem zugeordneten Wafer (90) getragen zu werden, wobei der Abschirmring (62) eine umlaufende äußere Randzone (94) an einer oberen Oberfläche (96) des zugeordneten Wafers (90) abschirmt, wobei die umlaufende äußere Randzone (94) ringförmig ist, eine radiale Breite aufweist und sich in Umfangsrichtung entlang eines umlaufenden Randes (92) des Wafers (90) erstreckt,
wobei ein Oberflächenteil (64, 65) des Abschirmrings (62) einen nominellen Oberflächenbereich (66) definiert, der ein Oberflächenbereich des Oberflächenteils (64, 65) ist, wenn dieser flach wäre, wobei der Oberflächenteil (64, 65) eine Oberflächenstruktur (70) aufweist, die einen vergrößerten Oberflächenbereich (68) bereitstellt,
wobei ein Verhältnis des vergrößerten Oberflächenbereichs durch den vergrößerten Oberflächenbereich (68) des die Oberflächenstruktur (70) aufweisenden Oberflächenteils (64, 65) dividiert durch den nominellen Oberflächenbereich (66) definiert ist, wobei das Verhältnis des vergrößerten Oberflächenbereichs größer als 1,5 ist.

2. Die Halbleitersubstratverarbeitungsvorrichtung nach Anspruch 1, wobei der Oberflächenteil des Abschirmrings (62) mit dem vergrößerten Oberflächenbereich (68) ausschließlich eine obere Oberfläche (64) des Abschirmrings (62) umfasst.

3. Die Halbleitersubstratverarbeitungsvorrichtung nach Anspruch 1, wobei der Oberflächenteil des Abschirmrings (62) mit dem vergrößerten Oberflächenbereich (68) ausschließlich eine untere Oberfläche (65) des Abschirmrings (62) umfasst.

4. Die Halbleitersubstratverarbeitungsvorrichtung nach Anspruch 1, wobei der Oberflächenteil (64, 65) des Abschirmrings (62) mit dem vergrößerten Oberflächenbereich (68) sowohl eine obere Oberfläche (64) als auch eine untere Oberfläche (65) des Abschirmrings (62) umfasst.

5. Die Halbleitersubstratverarbeitungsvorrichtung nach einem der Ansprüche 1-4, wobei die Oberflächenstruktur (70) eine Beschichtung umfasst, die eine Rauheit bereitstellt.

6. Die Halbleitersubstratverarbeitungsvorrichtung nach einem der Ansprüche 1-5, wobei der Abschirmring (62) aus einem Konstruktionsmaterial hergestellt ist, wobei die Oberflächenstruktur (70) geometrische Formen umfasst, die in dem Konstruktionsmaterial bereitgestellt sind.

7. Die Halbleitersubstratverarbeitungsvorrichtung nach einem der Ansprüche 1-6, wobei der Oberflächenteil (64, 65) mit dem vergrößerten Oberflächenbereich (68) eine Beschichtung umfasst, die Siliciumdioxid (SiO₂) umfasst.

8. Die Halbleitersubstratverarbeitungsvorrichtung nach einem der Ansprüche 1-7, wobei mindestens der Oberflächenteil (64, 65) mit dem vergrößerten Oberflächenbereich (68) des Abschirmrings (62) poröses Material umfasst.

9. Die Halbleitersubstratverarbeitungsvorrichtung nach einem der Ansprüche 1-8, wobei der Abschirmring (92) eine radiale Breite aufweist, die derart gewählt ist, dass die umlaufende äußere Randzone (94), die durch den Abschirmring (92) abgeschirmt wird, eine Breite im Bereich von 10 mm bis 30 mm aufweist.

10. Die Halbleitersubstratverarbeitungsvorrichtung nach einem der Ansprüche 1-9, wobei der Abschirmring (62) eine Waferstütze (20) ist, umfassend:
einen Stützbereich (22), der dazu konfiguriert ist, mindestens einen umlaufenden Rand (92) eines Wafers (90) der Vielzahl von Wafern (90) zu stützen, wobei der Stützbereich (22) eine zentrale Öffnung (30) aufweist, die einen Durchmesser aufweist, der kleiner als ein Durchmesser des Wafers (90) ist; und
einen Flansch (24), der den Stützbereich (22) in Umfangsrichtung umgibt, wobei der Flansch (24) in den Schlitzen (18) aufnehmbar ist und durch diese gestützt wird, wobei der Flansch (24) eine Breite aufweist, um einen Abstand (28) zwischen dem umlaufenden Rand (92) des Wafers (90) der Vielzahl von Wafern (90) und den Waferbootpfosten (18) des Waferboots (54) zu erzeugen, wobei der Abstand (28) derart ist, dass die Waferbootpfosten (18) eine Schichtdicke der Schicht, die während der Verarbeitung des Wafers (90) auf dem Wafer (90) abgeschieden wird, im Wesentlichen nicht beeinflussen.

11. Die Halbleitersubstratverarbeitungsvorrichtung nach Anspruch 10, wobei die Waferstütze (20) einen verdickten Randabschnitt (25) umfasst, der einen Waferauffangrand (25') bildet.

12. Die Halbleitersubstratverarbeitungsvorrichtung nach einem der Ansprüche 1-9, wobei der Abschirmring (62) zwischen Wafern (90) in dem Waferboot (54) in Abschirmringschlitzen (58) aufgenommen ist, die zwischen Waferschlitzen (60) positioniert sind, die zur Aufnahme von Wafern (90) in dem Waferboot (54) konfiguriert sind.

## Revendications

1. Appareil de traitement de substrats semi-conducteurs (10), comprenant :
- une chambre de traitement (12) configurée pour un traitement par lots d'une pluralité de tranches (90), dans lequel le traitement comporte le dépôt d'une couche sur chaque tranche (90) de la pluralité de tranches (90) ;
- une nacelle de tranche (14 ; 54) configurée pour recevoir la pluralité de tranches (90) et pouvant être logée dans la chambre de traitement (12), la nacelle de tranche (54) comprenant au moins deux montants de nacelle de tranche (16 ; 56), dans lequel chaque montant de nacelle de tranche (16 ; 56) comprend une pluralité de fentes (18 ; 58, 60) ; et
- un anneau de protection (62) configuré pour être supporté dans les fentes (18 ; 58) des montants de nacelle de tranche (18 ; 56) au-dessus d'une tranche (90) associée, l'anneau de protection (62) protégeant une zone de bord extérieure circonférentielle (94) au niveau d'une surface supérieure (96) de la tranche (90) associée, la zone de bord extérieure circonférentielle (94) étant en forme d'anneau, ayant une largeur radiale et s'étendant sur la circonférence le long d'un bord circonférentiel (92) de la tranche (90),
dans lequel
une partie de surface (64, 65) de l'anneau de protection (62) définit une superficie nominale (66) qui est une superficie de la partie de surface (64, 65) si celle-ci était plane, dans lequel la partie de surface (64, 65) a une structure de surface (70) qui assure une superficie accrue (68),
dans lequel un rapport de superficie accrue est défini par la superficie accrue (68) de la partie de surface (64, 65) ayant la structure de surface (70) divisée par la superficie nominale (66), dans lequel le rapport de superficie accrue est supérieur à 1,5.

2. Appareil de traitement de substrats semi-conducteurs selon la revendication 1, dans lequel la partie de surface de l'anneau de protection (62) avec la superficie accrue (68) comprend exclusivement une surface supérieure (64) de l'anneau de protection (62).

3. Appareil de traitement de substrats semi-conducteurs selon la revendication 1, dans lequel la partie de surface de l'anneau de protection (62) avec la superficie accrue (68) comprend exclusivement une surface inférieure (65) de l'anneau de protection (62).

4. Appareil de traitement de substrats semi-conducteurs selon la revendication 1, dans lequel la partie de surface (64, 65) de l'anneau de protection (62) avec la superficie accrue (68) comprend à la fois une surface supérieure (64) et une surface inférieure (65) de l'anneau de protection (62).

5. Appareil de traitement de substrats semi-conducteurs selon l'une des revendications 1 à 4, dans lequel la structure de surface (70) comprend un revêtement qui confère une rugosité.

6. Appareil de traitement de substrats semi-conducteurs selon l'une des revendications 1 à 5, dans lequel l'anneau de protection (62) est fabriqué à partir d'un matériau de construction, dans lequel la structure de surface (70) comprend des formes géométriques qui sont prévues dans le matériau de construction.

7. Appareil de traitement de substrats semi-conducteurs selon l'une des revendications 1 à 6, dans lequel la partie de surface (64, 65) avec la superficie accrue (68) comprend un revêtement comprenant du dioxyde de silicium (SiO₂).

8. Appareil de traitement de substrats semi-conducteurs selon l'une des revendications 1 à 7, dans lequel au moins la partie de surface (64, 65) avec la superficie accrue (68) de l'anneau de protection (62) comprend un matériau poreux.

9. Appareil de traitement de substrats semi-conducteurs selon l'une des revendications 1 à 8, dans lequel l'anneau de protection (92) a une largeur radiale qui est choisie de sorte que la zone de bord extérieure circonférentielle (94) qui est protégée par l'anneau de protection (92) ait une largeur dans la plage de 10 mm à 30 mm.

10. Appareil de traitement de substrats semi-conducteurs selon l'une des revendications 1 à 9, dans lequel l'anneau de protection (62) est un support de tranche (20) comprenant :
une aire de support (22) configurée pour supporter au moins un bord circonférentiel (92) d'une tranche (90) de la pluralité de tranches (90), dans lequel l'aire de support (22) a une ouverture centrale (30) ayant un diamètre qui est inférieur à un diamètre de la tranche (90) ; et
une bride (24) entourant l'aire de support (22) sur la circonférence, dans lequel la bride (24) peut être logée dans les fentes (18) et supportée par celles-ci, dans lequel la bride (24) a une largeur permettant de créer une distance (28) entre le bord circonférentiel (92) de la tranche (90) de la pluralité de tranches (90) et les montants de nacelle de tranche (18) de la nacelle de tranche (54), dans lequel la distance (28) est telle que les montants de nacelle de tranche (18) n'ont pratiquement pas d'effet sur une épaisseur de couche de la couche qui est déposée sur la tranche (90) pendant le traitement de la tranche (90).

11. Appareil de traitement de substrats semi-conducteurs selon la revendication 10, dans lequel le support de tranche (20) comprend une partie de bord épaissie (25) qui forme un bord de retenue de tranche (25').

12. Appareil de traitement de substrats semi-conducteurs selon l'une des revendications 1 à 9, dans lequel l'anneau de protection (62) est reçu entre les tranches (90) dans la nacelle de tranche (54) dans des fentes d'anneau de protection (58) qui sont positionnées entre des fentes de tranche (60) qui sont configurées pour recevoir les tranches (90) dans la nacelle de tranche (54).
